Europäisches Patentamt

(19) European Patent Office

Office européen des brevets

(11) Publication number: **0 113 549**

**A1**

# (12) EUROPEAN PATENT APPLICATION

(21) Application number: **83307456.0**

(22) Date of filing: **07.12.83**

(51) Int. Cl.³: **F 42 D 1/04**
**G 01 R 27/02**

(30) Priority: **10.12.82 GB 8235357**

(43) Date of publication of application:
**18.07.84 Bulletin 84/29**

(84) Designated Contracting States:
**BE DE FR SE**

(71) Applicant: **TROLEX PRODUCTS LIMITED**
**Newby Road Hazel Grove**
**Stockport Cheshire SK7 5DY(GB)**

(72) Inventor: **Hyde, Donald**
**10 Willowbank Cheadle Hulme**
**Stockport Cheshire(GB)**

(72) Inventor: **Bruchez, Jules**
**3 Sutton road Poynton**
**Stockport Cheshire(GB)**

(74) Representative: **Low, Peter John et al,**
**WILSON, GUNN & ELLIS 41 Royal Exchange**
**Manchester, M2 7BD(GB)**

(54) Impedance sensor.

㊼ An impedance sensor (15) which comprises means for generating a sense current to produce a signal representing the impedance of a load at a search current and means for correcting the signal representing the impedance at said search current to a level substantially equivalent to the impedance at a higher current from the output transformer (34).

Fig. 1

- 1 -

## IMPEDANCE SENSOR

This invention relates an impedance sensor which has particular application to exploders for toroid coupled detonators.

Toroid coupled detonators provide a very convenient means by which a large number of detonators can be rapidly linked to an exploder. A particularly useful exploder arrangement for toroid coupled detonators is described in the specification of European Patent Application No 54402. The exploder essentially comprises a power oscillator which delivers the firing current at a frequency adjusted by frequency setting means to the resonant frequency of the load. Preferably, prior to firing, the oscillator generates a search current which is applied to the circuit to determine the impedance thereof and hence the appropriate voltage to be applied to the power oscillators for them to deliver the requisite firing current.

In practice the search current is usually of the order of 20 mA and is very much less that the firing current which may be for example of the order of 6 A. We have now discovered that the impedance as determined by the small search current is not the same as the impedance when the full firing current is applied. This means that, in fact, the voltage applied to the power oscillators as a consequence of the search current may not be appropriate to the impedance of the circuit when it receives the firing current.

The present invention has been made with this problem in mind.

According to the invention there is provided an impedance sensor comprising means for generating a search current to produce a signal representing the impedance of a load at said search current and means for correcting the signal indicative of impedance measured by the search current to a level substantially equivalent to the impedance at a higher current.

In a preferred embodiment of the invention the impedance sensor is incorporated in an exploder, particularly an exploder for toroid coupled detonators. The exploder includes means responsive to the corrected signal indicative of impedance to fix the voltage applied to an oscillator for producing a firing current, said search current being a fraction of the firing current. Preferably the exploder also comprises frequency setting means to which the oscillator is responsive to produce the firing current at the resonant frequency of the load. By using the impedance sensor with the exploder the voltage applied to the oscillator is correctly matched to the impedance of the load at the firing current.

A meter, for example a moving coil or digital meter, is preferably coupled to the output of the impedance sensor which will give a visual indication of the impedance of the load at the higher frequency. When the impedance sensor is used in combination with an exploder such a meter can be used not only to indicate the impedance of the load at the firing current but also as a check that the firing current is properly connected.

A specific embodiment of the invention will now be described by way of example with reference to the accompanying drawings in which :-

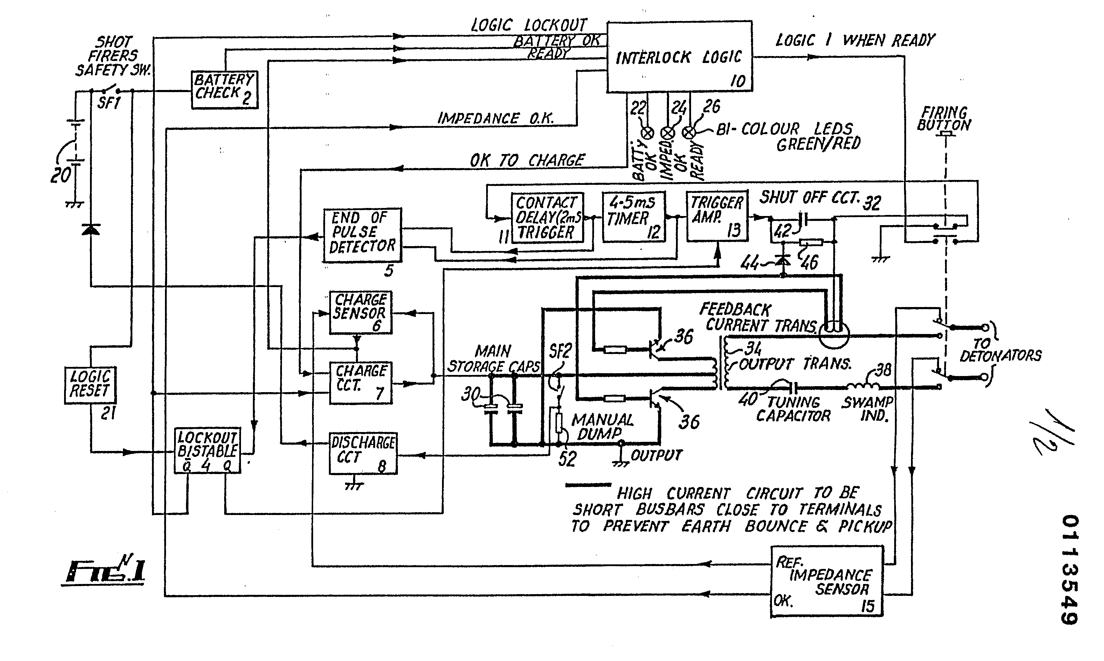

Fig 1 is a block diagram of an exploder; and

Fig 2 is a more detailed circuit diagram of the impedance sensor.

Referring to the drawings the exploder is, in principle, similar to the exploder as disclosed in the aforesaid specification of European Patent Application No 54402 and will not, therefore, be described in detail.

When safety switch SF 1/2 is closed a battery

0113549

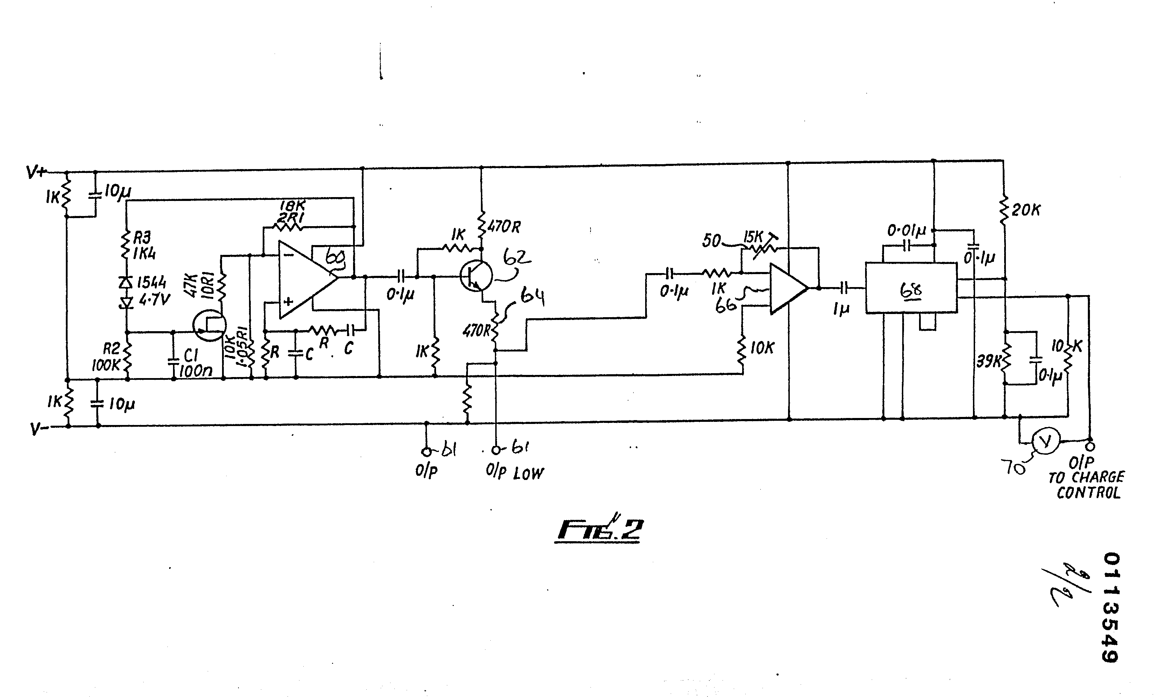

check unit 2 senses the voltage of battery 20. If the voltage is above a predetermined level light emitting diode 22 "Battery OK" is changed from red to green.   On sensing of adequate voltage level, the interlock circuit 10 permits the impedance sensor circuit 15 to generate a small search current, of for example 20 mA, for determining the impedance of the firing circuit.   The sensor circuit 15 produces an analogue reference voltage proportional to the impedance measured at the search current which is corrected by variable resistor 50 (Fig.2) to more closely represent the impedance of the firing circuit when the firing current is applied thereto.   As shown in Fig.2 the impedance sensor circuit comprises an integrated circuit 60 adapted to operate as an amplifier and being part of an oscillator of very high stability over a wide range of temperature and voltage.   The frequency of the oscillator is set at about 15 to 16 $KH_z$ which is the frequency of the most inductive load that might be connected to the exploder.

The output from the integrated circuit 60 is connected to the load, connected across terminals 61, via emitter follower 62 and safety resistor 64 to prevent accidental firing.

Integrated circuit 66 which is an operational amplifier is adapted to examine the firing circuit signal..

The amplifier has a gain of about ten for adjusting the small firing circuit signal to a usable level. Adjustment of the output of the amplifier can be effected by the variable resistor 50. The amplified output is then converted to a DC signal by converter 68, the resultant signal being proportional to the impedance of the firing circuit.

The output from the impedance sensor is fed to the charge sensor circuit 6 to set a reference therein which determines the voltage to be applied to the power oscillators 36. Description of the further operation of the exploder is not necessary to an understanding of the present invention, but is disclosed in our co-pending British Patent Application No.8235358.

A digital or analogue meter 70 can be connected to the output of the sensor. By adjustment of resistor 50 the meter 70, appropriately calibrated, can be set to indicate the impedance of the firing circuit.

Although the specific embodiment describes an impedance sensor used in combination with an exploder it is to be understood that the invention is not restricted to that combination.

CLAIMS

1.    An impedance sensor comprising means for generating a search current to produce a signal representing the impedance of a load at said search current and means for correcting the signal indicative of impedance measured by the search current to a level substantially equivalent to the impedance at a higher current.

2.    An impedance sensor as claimed in Claim 1, wherein a meter is coupled to the output to provice a visual indication of the impedance at the higher current.

3.    An impedance sensor as claimed in Claim 1 or Claim 2, wherein the means for correcting the signal indicative of impedance measured by the search current comprises a variable resistance.

4.    An impedance sensor as claimed in any preceding Claim in combination with an exploder comprising means responsive to the corrected signal indicative of impedance to fix the voltage applied to an oscillator for producing a firing current to be applied to the load.

5.    An impedance sensor in combination with an exploder as claimed in Claim 4, wherein the exploder further comprises frequency setting means to which the oscillator is responsive to cause the oscillator to produce the firing current at the resonsant frequency of the load.

6.    An impedance sensor substantially as described herein with reference to the accompanying drawings.

FIG. 1

SHOT FIRERS SAFETY SW. — SF1

BATTERY CHECK 2

LOGIC LOCKOUT

BATTERY OK / READY

INTERLOCK LOGIC 10

LOGIC 1 WHEN READY

IMPEDANCE O.K.

22 24 26

BI-COLOUR LEDS GREEN/RED

BATT'Y OK / IMPED OK / READY

OK TO CHARGE

FIRING BUTTON

END OF PULSE DETECTOR 5

CONTACT DELAY (2mS) TRIGGER 11

4·5mS TIMER 12

TRIGGER AMP. 13

SHUT OFF CCT. 32

42 44 46

LOGIC RESET 21

CHARGE SENSOR 6

CHARGE CCT. 7

MAIN STORAGE CAPS 30

SF2

36

36

FEEDBACK CURRENT TRANS. 34

OUTPUT TRANS. 38

TO DETONATORS

LOCKOUT BISTABLE Q̄ 4 Q

DISCHARGE CCT. 8

52

MANUAL DUMP

OUTPUT

40 TUNING CAPACITOR

SWAMP IND.

HIGH CURRENT CIRCUIT TO BE SHORT BUSBARS CLOSE TO TERMINALS TO PREVENT EARTH BOUNCE & PICKUP

REF. IMPEDANCE SENSOR OK. 15

20

1/2

0113549

_FIG.2_

## DOCUMENTS CONSIDERED TO BE RELEVANT

| Category | Citation of document with indication. where appropriate, of relevant passages | Relevant to claim | CLASSIFICATION OF THE APPLICATION (Int. Cl. ³) |
|---|---|---|---|
| Y | DE-C-1 117 016 (NOBEL-BOZEL)<br>* Column 4, line 51 - column 5, line 19; figure 1 * | 1,4 | F 42 D 1/04<br>G 01 R 27/02 |
| Y | GB-A-1 604 012 (ARBRA INSTRUMENTS)<br>* Page 2, lines 78-99; figure * | 1,4 | |
| A | US-A-3 387 211 (W.S. KAUFMANN et al.)<br>* Column 1, line 11 - column 2, line 6 * | 1 | |
| D,A | EP-A-0 054 402 (ICI)<br><br>* Claims 1-10; figure 5 * | | |

TECHNICAL FIELDS SEARCHED (Int. Cl. ³)

F 42 D 1/04
G 01 R 27/02

The present search report has been drawn up for all claims

| Place of search<br>BERLIN | Date of completion of the search<br>05-03-1984 | Examiner<br>LEMMERICH J |
|---|---|---|